# EUROPEAN PATENT APPLICATION

(11) **EP 4 734 366 A1**
(43) Date of publication of application: **29.04.2026**
(21) Application number: 25205365.7
(22) Date of filing: 29.09.2025
(51) Int. Cl.: H03G 3/30, H04R 1/10, A63F 13/28, A63F 13/285, B60N 3/06, G06F 3/01, G06F 3/16, G08B 6/00, G09B 5/06, H04R 1/24, H04R 3/00

(54) **PROCESSING AUDIO INPUTS TO PRODUCE TACTILE OUTPUTS**

(30) Priority: 24.10.2024 US 202463711596 P; 17.09.2025 US 202519331277
(71) Applicant: Harman International Industries, Incorporated, Stamford, CT 06901 (US)
(72) Inventor: Daftuar, Rishi Kumar, Stamford, 06901 (US); Schmidt, Skyler Lee, Stamford, 06901 (US); Mossington, David Reid, Stamford, 06901 (US); Concessi, Kyle Thomas, Stamford, 06901 (US)
(74) Representative: Kraus & Lederer PartGmbB

(57) **Abstract**

In one embodiment, a computer-implemented method includes receiving an input audio signal for playback by at least one speaker and at least one tactile transducer, receiving a control signal associated with a user-specified setting for the at least one tactile transducer, and generating a processed audio signal to drive the at least one tactile transducer, wherein the processed audio signal is adjusted based on the control signal independent of a speaker output signal driving the at least one speaker.

## Description

### BACKGROUND

### Field of the Various Embodiments

Embodiments of the present disclosure relate generally to audio systems and, more specifically, to processing audio inputs to produce tactile outputs.

### Description of the Related Art

Tactile transducers, often called shakers or haptic transducers, are commonly integrated within vehicle seating, cinema chairs, and gaming setups to generate vibrations that are synchronized with an accompanying audio signal. Conventional architectures extract low-frequency audio signals by summing two separate channels (stereo channels) and applying a fixed low-pass filter, followed by delivery to a power amplifier that excites an electromechanical shaker configured within a tactile transducer setup such as a seat frame or cushion. Signal conditioning in such arrangements is limited to filters and fixed-ratio gain stages that preserve sub-bass information while attenuating mid-band content. A single mono drive path is often employed, thereby discarding low-frequency left-versus-right channel information (stereo cues) and imposing a uniform excitation profile on every installed transducer regardless of physical location or mechanical coupling.

One drawback of traditional tactile transducers systems is sensitivity to media-dependent loudness variation. For example, a contemporary pop mix containing substantial bass below roughly a cut-off frequency can drive a transducer into vigorous vibrations, whereas a jazz recording mastered at a lower overall level may generate little perceptible vibration. An occupant transitioning between different media types must therefore adjust tactile gain manually or endure pronounced shifts in perceived intensity.

Yet another drawback is that user customization options remain limited in traditional tactile transducer systems. Traditional tactile transducer systems provide master-level trimming or coarse equalization, leaving sudden transients and wide dynamic swings unmanaged and often uncomfortable. For example, some tactile transducer system implementations lack independent adjustment of vibrational strength relative to loudspeaker volume, fail to permit allocation of different intensities to distinct regions of a multi-transducer seat, and omit compensation for content mastered at divergent loudness levels.

As the foregoing illustrates, what is needed in the art are more effective techniques for processing audio inputs to produce tactile outputs.

### SUMMARY

One embodiment of the present application sets forth a computer-implemented method. The method includes receiving an input audio signal for playback by at least one speaker and at least one tactile transducer, receiving a control signal associated with a user-specified setting for the at least one tactile transducer, and generating a processed audio signal to drive the at least one tactile transducer, wherein the processed audio signal is adjusted based on the control signal independent of a speaker output signal driving the at least one speaker.

Other embodiments of the present disclosure include, without limitation, a computer-readable medium including instructions for performing one or more aspects of the disclosed techniques as well as a computing device for performing one or more aspects of the disclosed techniques.

At least one technical advantage of the disclosed techniques relative to prior art is the provision of automatic loudness-based gain control. The gain control delivers perceptually uniform vibration across audio signals with different intensity levels. Consequently, the gain control eliminates manual track-by-track calibration and prevents either under-stimulation or excessive discomfort vibrations. Additional advantages include multiband processing in which the audio signal is split into several frequency bands so vibration can be matched to different frequency bands. In addition, mid/side audio signal processing preserves stereophonic separation. Furthermore, user-based selections enable customization of different vibration intensities to different tactile transducers.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
FIG. 1 illustrates a schematic diagram of an audio system configured to implement one or more aspects of the various embodiments;
FIG. 2 is a more detailed illustration of the functioning of an audio output application, configured to implement one or more aspects of the various embodiments;
FIG. 3A is a more detailed illustration of an individual tactile processing unit, configured to implement one or more aspects of the various embodiments;
FIG. 3B is a more detailed illustration of a tone generator control, configured to implement one or more aspects of the various embodiments;
FIG. 4 illustrates an example of a vehicle-based audio system, according to various embodiments; and
FIG. 5 is a flow diagram of method steps for generating a processed audio signal from an input audio signal, according to various embodiments.

### DETAILED DESCRIPTION

In the following description, numerous specific details are set forth to provide a more thorough understanding of various embodiments. However, it will be apparent to those skilled in the art that the inventive concepts may be practiced without some or all of these specific details.

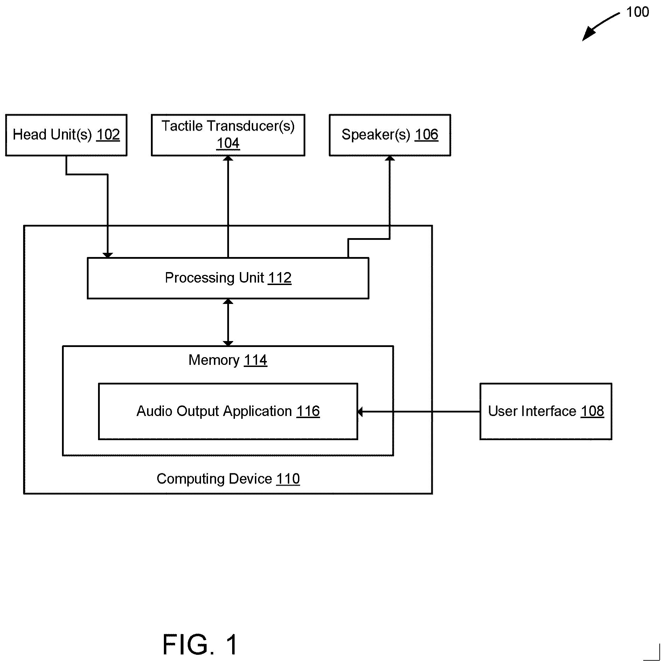

Figure 1 illustrates a schematic diagram of an audio system 100 according to various embodiments. As shown, the audio system 100 includes, without limitation, one or more head units 102, one or more tactile transducers 104, one or more speakers 106, a user interface 108, and a computing device 110. Computing device 110 includes, without limitation, a processing unit 112, a memory 114, and an audio output application 116. Audio output application 116 interfaces with user interface 108, tactile transducer 104, and speaker 106.

Head unit 102 includes, without limitation, any technically feasible device or component capable of providing audio signals to computing device 110 based on an audio source that is being played back by the audio system 100. For example, each of the one or more head units 102 includes a media player that accesses terrestrial or satellite radio, a streaming service accessed via a network connection, a local media stream (e.g., from a cellular or smart telephone), or a storage device containing music, movie soundtracks, spoken word content, or other audio files. In some embodiments, head unit 102 can adapt or switch audio content based on user preferences, sensor input, system configurations, and/or the like. Once head unit 102 generates the audio signal, computing device 110 processes the audio signal, and drives tactile transducer 104 and speaker 106 based on user interface 108 selections. In some embodiments, the computing device 110 is integrated into the head unit 102.

Tactile transducer 104 represents one or more devices or components configured to convert an electrical drive signal into mechanical vibrations perceptible to one or more listeners. For example, a tactile transducer 104 includes seat-mounted actuators, voice-coil shakers, moving-magnet exciters, linear-resonant actuators, piezoelectric benders, and/or the like. Each of the one or more tactile transducers 104 can be mounted to, embedded within, or mechanically coupled to a support surface such as a seat base, seatback, headrest, armrest, floor panel, gaming chair platform, and/or the like located within a passenger compartment, home-theatre environment, wearable assembly, and/or the like. The electrical drive signal is supplied by computing device 110 and is derived from an audio signal originating at head unit 102 and processed by audio output application 116 based on user interface 108 selections. Tactile transducer 104 can generate vibrations related to any audio signal including bass-heavy music, cinematic audio effects, bass notes, or other audio signal-based vibrations capable of enhancing immersive user experience.

In various embodiments, each of the one or more tactile transducers 104 receives mutually independent electrical drive signal, enabling spatially distributed vibration patterns. For example, audio output application 116 can direct stronger vibration to tactile transducer 104 mounted in a seat cushion while supplying reduced-amplitude signals to transducers mounted in a seatback, thereby providing user-selected intensity or tactile experience. In some embodiments, the electrical drive signal supplied to tactile transducer 104 is bandwidth-limited (e.g.., below a cutoff frequency 200 Hz).

Speaker 106 represents one or more devices or components configured to convert amplified or pre-amplified electrical drive signals into audible sound perceptible to one or more listeners. For example, loudspeakers, coaxial drivers, component speakers, tweeters, subwoofers, or any combination thereof. Each of the one or more speakers 106 can be positioned or integrated within headrests, seatbacks, door panels, dashboards, custom enclosures, overhead compartments, vehicle pillars, or other suitable locations within a passenger compartment, home-theatre environment, gaming setup, wearable assembly, and/or the like. Speaker 106 receives amplified or pre-amplified electrical drive signals from computing device 110 or another source (not shown), based on audio signals generated by head unit 102. In some embodiments, speaker 106 includes multiple speaker channels such as front left, front right, center, rear surround, overhead presence, or upward-directed speakers, enabling spatial audio reproduction and targeted sound rendering techniques. Amplified or pre-amplified electrical drive signals can be routed selectively to each of the one or more speakers 106 based on spatial, directional, frequency-range, or content-specific configurations to enhance immersive audio experiences or to match user preferences.

User interface 108 represents any hardware and/or software components configured to enable a user to control various aspects of audio output application 116. Examples of devices that facilitate user input via a user interface 108 include, without limitation, touchscreens, rotary knobs, dials, physical buttons, keyboards, sliders, joysticks, pen-and-touch systems, gesture-based controls, capacitive sensors, haptic touchpads, voice-command input systems, motion-sensing controllers, and/or the like. User interface 108 can also include associated output devices such as visual displays or auditory feedback components. Visual displays include LCD panels, OLED screens, LED displays, e-ink displays, projection-based displays, heads-up displays (HUDs), and/or the like. Auditory feedback components include synthesized voice outputs, tone indicators, or pre-recorded prompts confirming user selections. Any technically feasible interface capable of communicating user selections to computing device 110 and providing confirmatory feedback is included within the scope of user interface 108.

User interface 108 provides user controls for intensity control, volume control, and experience setting control. Each intensity control, volume control, and experience setting control is presented to one or more users via user interface 108 and is accompanied by visual, auditory, and/or haptic feedback confirming control or adjustment. User interface 108 outputs a control signal corresponding to a selected intensity control, volume control, and experience setting control selected by a user. In some embodiments, user interface 108 outputs separate control signals corresponding to each of the different controls that can be selected by a user.

Intensity control enables one or more users to adjust overall vibration intensity via controlling gain parameters of each of the one or more tactile transducers 104. The intensity control provided by a user in the user interface 108 is translated by computing device 110 into a static or slowly varying gain value. The static or slowly varying gain value can modify the amplitude of an electrical drive signal delivered to the one or more tactile transducers 104 without affecting the audible playback level generated by speakers 106. In some embodiments, intensity control can include a rotary dial, a vertical slider on a touchscreen, a voice command (e.g., increase seat vibration), or any other user input mechanism. In one embodiment, audio output application 116 translates the intensity control setting selected by the user via the user interface 108 into an intensity setting retrieved from an intensity lookup table.

Experience setting control provides the user the ability to select or configure among various predefined or user-configured tactile experiences and independent of the output characteristics of the speakers 106. Each tactile experience specifies a gain vector, per-channel delay values, transient shaping parameters, and/or routing matrix coefficients that determine how a group or sub-group of tactile transducers 104 within a seat generates vibrations (e.g., driver seat group, back seat group, passenger side group, and/or the like). Delay values enable varying the timing between individual tactile transducers 104 or groups of tactile transducers 104 to generate different perceptual feelings. Tactile transducers 104 can be separated into and driven based on groups or sub-groups. Groups or sub-groups of tactile transducers 104 can be identified based on their location within a vehicle, such as which seat or portion of a seat in which tactile transducers 104 are installed. Transient shaping parameters adjust attack, sustain, and decay characteristics of the electrical drive signal to modify perceived user feelings. For example, in tactile experience that can be termed as a "punch" setting corresponds to a seat-wide configuration that emphasizes strong, transient-rich vibrations across tactile transducers, while a tactile experience labeled "Smooth" corresponds to a different configuration that emphasizes sustained low-frequency vibrations for a more rumble-like feel. In other embodiments, experience setting control can include a mode-selection button that cycles through icons on a display, a touchscreen menu showing tactile experience names, or a gesture recognized by a cabin camera. Audio output application 116 translates the tactile experience selected by one or more users into tactile experience parameters retrieved from a tactile experience lookup table.

Volume control adjusts output volume via equalization parameters and level parameters (e.g., gain, frequency bands, and/or other volume control parameters) applied downstream of the intensity control and experience setting controls and independent of the output level of the speakers 106. The volume control scales a tactile drive signal, thereby adjusting the overall loudness of haptic output. In some embodiments, volume control can include a primary audio-system knob, steering-wheel buttons, up/down keys, touchscreen adjustment elements, or a voice recognition command (e.g., "set volume to fifty percent"). Audio output application 116 translates the volume control setting selected by the user into volume parameters retrieved from a volume lookup table.

User interface 108 allows saving and recalling custom combinations of intensity control, experience setting control, and volume control parameters, applying manufacturer-supplied presets, locking controls for child safety, and synchronizing settings across multiple seats or user profiles. All such interactions, whether accomplished via physical actuation, voice command, or remote device linkage, are within the scope of user interface 108.

Computing device 110 is a dedicated processing module. In some embodiments, computing device 110 is included in one or more devices, such as consumer products (e.g., portable speakers, gaming consoles, entertainment systems, etc.), vehicles (e.g.., the head unit of a car, truck, van, bus, train, airplane, or other vehicle), smart home devices (e.g., smart lighting systems, security systems, digital assistants, etc.), communications systems (e.g., conference call systems, video conferencing systems, speaker amplification systems, etc.), mobile devices (e.g., smart phones, tablets, etc.), or computers.

Computing device 110 includes processing unit 112, which can be any suitable processor, such as a central processing unit (CPU), a graphics processing unit (GPU), an application-specific integrated circuit (ASIC), a field programmable gate array (FPGA), a digital signal processor (DSP), and/or any other type of processing unit, including combinations thereof, such as a CPU configured to operate in conjunction with a GPU. In general, the processing unit 112 can be any technically feasible hardware unit capable of processing data and/or executing software applications.

Processing unit 112 represents any suitable hardware component configured to process data, execute software applications, and perform computational tasks associated with audio output application 116. In operation, processing unit 112 executes audio output application 116 to generate electrical drive signal for tactile transducer 104. In some embodiments, processing unit 112 additionally generates one or more amplified or pre-amplified electrical drive signals for speaker 106.

Memory 114 can include a random-access memory (RAM) module, a flash memory unit, or any other type of memory unit or combination thereof. Processing unit 112 is configured to read data from and write data to memory 114. In various embodiments, memory 114 includes non-volatile memory, such as optical drives, magnetic drives, flash drives, or other storage. In some embodiments, separate data stores, such as an external data store included in a network (e.g., cloud storage) can supplement memory 114. Audio output application 116 within memory 114 can be executed by the processing unit 112 to implement the overall functionality of the computing device 110. In various embodiments, an interconnect bus (not shown) connects processing unit 112, memory 114 and any other components of the computing device 110.

Audio output application 116 is executed by processing unit 112 to generate electrical drive signals supplied to tactile one or more tactile transducers 104. In operation, audio output application 116 receives an input audio signal from head unit 102, applies a low-pass filter to isolate low-frequency audio content (e.g., below 200 Hz) of the input audio signal, and calculates the loudness of the filtered audio content using loudness units relative to full scale (LUFS), a perceptually weighted measure of audio loudness aligned with human auditory perception, or any other measure of the loudness of audio. In some embodiments, audio output application 116 employs a multiband filter that divides the low-frequency audio content (e.g., 20-200 Hz) into two or more contiguous sub-bands (e.g., 20-50 Hz, 50-80 Hz, 80-120 Hz, and 120-200 Hz). The low-pass filter generates a low-frequency signal or set of sub-band signals.

A level adjustor receives the low-frequency signal or set of sub-band signals and computes current loudness values in LUFS. The level adjustor compares the measured LUFS value with predetermined target values in LUFS. The level adjustor calculates a difference term between current loudness values and the predetermined target values and derives a rate-limited gain factor based on the difference term that is applied to the low-frequency signal or set of sub-band signals to generate a normalized audio signal and prevent abrupt gain changes.

Audio output application 116 also generates a periodic waveform via a tone generator, such as a triangle wave or square wave, that is activated when the normalized audio signal exceeds a predefined threshold level. The tone generator parameters, including waveform type, fundamental frequency, and gating threshold, are stored in memory 114. The normalized audio signal and the periodic waveform are provided to a tactile processing unit for additional signal processing, including mid-side stereo processing, clipping, limiting, and envelope shaping. The tactile processing unit processes the normalized audio signal and the periodic waveform separately for each of the one or more tactile transducers 104.

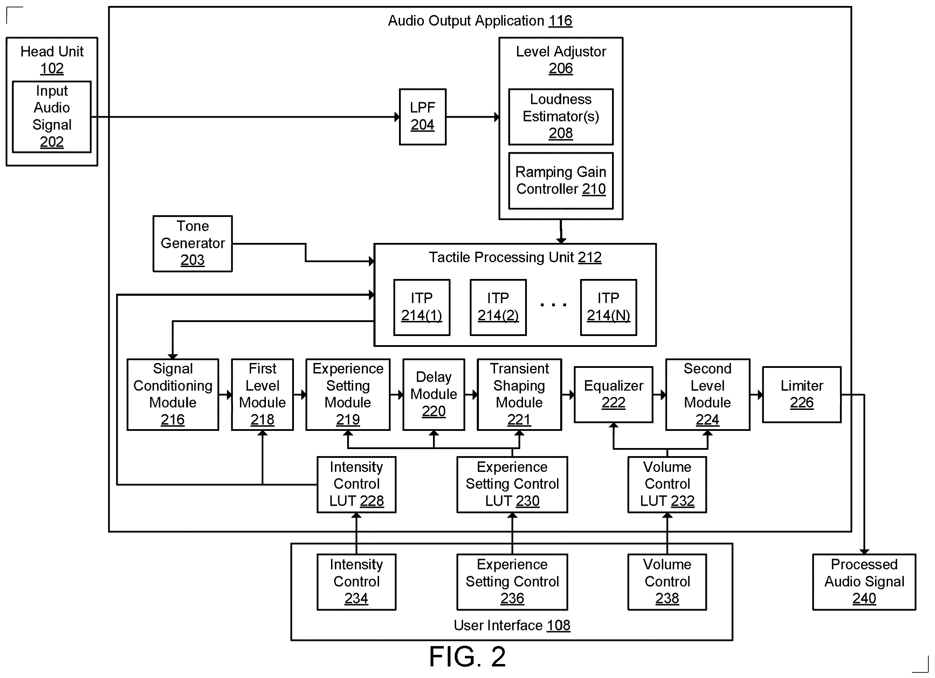

Audio output application 116 further applies user-specified intensity control, volume control, and experience setting control received from lookup tables stored in memory 114 to generate processed audio signal. Audio output application 116 enables consistency and customizable distribution of tactile sensations across diverse audio content and user preferences, thereby enhancing immersive audio-tactile experiences for one or more listeners. Audio output application 116 is described in further detail in FIG. 2.

FIG. 2 is a more detailed illustration of the functioning of audio output application 116, according to various embodiments. As shown, audio output application 116 receives input audio signal 202 within head unit 102 and generates a processed audio signal 240 based on settings made by a user via the user interface 108. Settings specified via the user interface 108 include, without limitation, an intensity control 234, an experience setting control 236, and a volume control 238. Audio output application 116 includes, without limitation, a tone generator 203, a low pass filter (LPF) 204, a level adjustor 206, a tactile processing unit 212, a signal conditioning module 216, a first level module 218, an experience setting module 219, a delay module 220, a transient shaping module 221, an equalizer 222, a second level module 224, a limiter 226, an intensity control LUT 228, an experience setting control LUT 230, and a volume control LUT 232. Level adjustor 206 includes, without limitation, one or more loudness estimators 208, and a ramping gain controller 210. Tactile processing unit 212 includes, without limitation, a plurality of individual tactile processing units (ITP) 214(i).

Audio output application 116 receives input audio signal 202, which represents an electrical audio signal provided by head unit 102. Input audio signal 202 can originate from any technically feasible audio source, including terrestrial or satellite radio broadcasts, audio streams from network-based services, local playback from a smartphone or other mobile device, stored media files containing music, movie soundtracks, spoken word recordings, podcasts, or any combination thereof. In some embodiments, input audio signal 202 can include one channel, two channels, or multiple discrete channels and can have any technically feasible length and sample rate.

LPF 204 is a digital or analog low-pass filter that isolates low-frequency audio content (e.g., below 200 Hz) of input audio signal 202. LPF 204 attenuates (e.g., by 60 dB) input audio signal 202 above a predetermined or programmable cutoff frequency (e.g., approximately 200 Hz), thereby extracting low-frequency audio content. In some embodiments, LPF 204 employs a multiband filter that divides the low-frequency audio content into two or more contiguous sub-bands (e.g., 20-50 Hz, 50-80 Hz, 80-120 Hz, and 120-200 Hz) to facilitate frequency-dependent processing. Filter parameters of LPF 204, including the cutoff frequency, are stored in memory 114 and can be updated or selected from a table according to tactile transducer 104 characteristics or vehicle-type presets. LPF 204 generates a low-frequency signal or a set of sub-band signals that is provided to level adjustor 206 for loudness estimation and normalization. Input audio signal 202 is provided to speaker-processing modules (not shown) as required to drive speaker 106.

Level adjustor 206 receives the low-frequency signal or the set of sub-band signals generated by LPF 204 and performs loudness estimation and normalization. Loudness estimator 208 calculates the loudness of the low-frequency signal or the set of sub-band signals using LUFS, a standard measurement aligned with human auditory perception. In operation, loudness estimator 208 continuously evaluates the low-frequency signal or the set of sub-band signals and updates computed LUFS values in real-time or at periodic intervals. In a low-frequency signal implementation (e.g., 200 Hz and below), level adjustor 206 employs loudness estimator 208 operating on the low-frequency signal. In a set of sub-band signals implementation (e.g., four sub-bands), level adjustor 206 employs a corresponding plurality of loudness estimators 208 (e.g., one per sub-band), each generating an independent LUFS value.

Ramping gain controller 210 applies a ramping gain adjustment based on a rate-limiting algorithm that gradually adjusts the gain factor to adjust loudness or amplitude of the low-frequency signal or the set of sub-band signals with current LUFS values toward loudness or amplitude of the low-frequency signal or the set of sub-band signals with target values in LUFS over a predefined duration to avoid abrupt changes in perceived tactile sensations. The ramping duration and/or minimum/maximum gain bounds can be selected or adjusted via parameters stored in memory 114, thereby providing smooth transitions between audio tracks of varying loudness. The gain factor is multiplied with the incoming low-frequency signal or the set of sub-band signals, generating a normalized audio signal. The normalized audio signal provides consistent tactile sensation levels across diverse audio content, enhancing the immersive experience of users. The normalized audio signal generated by level adjustor 206 is subsequently provided to tactile processing unit 212.

Tone generator 203 generates a periodic low-frequency waveform, such as a triangle wave or square wave, activated when the normalized audio signal exceeds a predefined threshold level determined by a tone generator control. Tone generator 203 parameters, including waveform type, fundamental frequency, and gating threshold, are stored in memory 114 and can be updated over time. Tone generator 203 can be implemented as a numerically controlled oscillator (NCO) generator, a wavetable synthesizer, or a hardware oscillator core embedded in processing unit 112.

Tactile processing unit 212 includes a set of N individual tactile processing units ITP 214(i) where N corresponds to an identifier of a tactile transducer 104 (e.g., four tactile transducers in a seat base and two in a seatback imply N = 6). Tactile processing unit 212 receives and processes the normalized audio signal generated by level adjustor 206, the periodic low-frequency waveform generated by tone generator 203, and the gain values from intensity control LUT 228. Tactile processing unit 212 generates an N-channel audio signal, where each channel is generated specifically for each of one or more tactile transducers 104. Each ITP 214(i) independently processes the received signals by tactile processing unit 212 for each of one or more tactile transducers 104.

Mid-side signal analysis within each ITP 214(i) separates the received signals using mid-side separation into mid and side components, or a weighted mixture thereof, enabling independent processing of shared and unique audio elements between left (L) and right (R) audio channels. The mid signal represents common audio content (L+R), and the side signal represents differential audio content (L-R). Mid-side signal analysis allows selective spatially informed processing of received signals, enhancing the immersive tactile experience by distributing processed received signals across tactile transducers based on the spatial characteristics of the received normalized audio signal generated by level adjustor 206.

Each ITP 214(i) individually processes the normalized audio signal generated by level adjustor 206 by performing clipping, limiting, and/or expanding operations for each left (L) and right (R) audio channels through an adjusted media module to manage and control dynamic range, preventing distortion and protecting tactile transducer 104 from excessive drive levels. Clipping modules apply instantaneous amplitude constraints, while limiting modules apply dynamic range compression based on configurable attack, hold, and release parameters stored in memory 114. Expanding operations increase the dynamic range of the audio signal, performing downward expansion to reduce the level of an audio signal below a specified threshold (e.g., making quiet signals quieter) or upward expansion to boost an audio signal above the specified threshold (e.g., making loud signals louder). Expansion parameters, including attack which represents the speed of expansion onset, release which represents the speed of recovery after expansion, threshold which represents the beginning of expansion, ratio which represents the amount of applied expansion, and range which represents the maximum gain change, are stored in memory 114 and can be updated or selected according to tactile transducer 104.

Each ITP 214(i) also includes a tone generator control for tone generator 203. Tone generator control monitors the amplitude of the normalized audio signal generated by level adjustor 206. When an instantaneous or short-term root mean square (RMS) level exceeds a programmable trigger threshold stored in memory 114 (e.g., -18 dBFS after normalization), the tone generator control asserts a trigger flag "T_ON." When the level falls below the programmable trigger threshold or after an adjustable hold-time expires, the detector de-asserts the flag. The tone generator control multiplies the output of tone generator 203 by an envelope. Envelope time constants (e.g., 5 ms attack, 50 ms hold, 10 ms release) are stored in memory 114.

Each individual ITP 214(i) performs further signal conditioning on the received signals based on intensity control LUT 228. Signal conditioning provides additional filtering, gain adjustments, delay adjustments, and summation as needed to generate a single channel audio signal. Tactile processing unit 212 aggregates outputs from each individual ITP 214(i) as the N channel audio signal, or a multi-channel signal. Tactile processing unit 212 sends the N channel audio signal to signal conditioning module 216.

In some embodiments tactile processing unit 212 sends the N channel audio signal through a N × N matrix mixer within signal conditioning module 216. Each mixer coefficient of the matrix mixer is selectable from a lookup table or set dynamically by audio output application 116, enabling arbitrary redistribution of audio signals among output channels before performing signal conditioning on the audio signals by signal conditioning module 216.

Signal conditioning module 216 performs additional processing operations on the N channel audio signal, including compression, gain adjustment, or equalization (EQ) to generate N channel conditioned audio signal. Compressor module within signal conditioning module 216 dynamically controls the dynamic range of each audio channel, smoothly reducing the N channel audio signal amplitude above a predetermined threshold based on configurable attack, hold, and release parameters stored in memory 114. Gain adjustment modules apply a fixed or configurable gain to scale the amplitude of the N channel audio signal. Equalizer module applies frequency-dependent filtering, such as parametric EQ, graphic EQ, or shelving filters, to selectively boost or attenuate specific frequency ranges of the N channel audio signal. Equalization parameters, including center frequency, bandwidth, and gain, are stored and retrieved from memory 114.

First level module 218 receives the N channel conditioned audio signal from signal conditioning module 216 and applies a static or slowly varying gain value to the N channel conditioned audio signal based on an intensity control signal. The intensity control signal is based on an intensity control 234 that represents user preferences selected by one or more users. In operation, a user can control intensity of each of the one or more tactile transducers 104 and/or a group of tactile transducers 104. The static or slowly varying gain values compensates for sensitivity differences, actuator aging, or installation tolerances. Audio output application 116 translates selected an intensity control signal corresponding to intensity control 234 to the static or slowly varying gain values using intensity control LUT 228. Intensity control 234 also provides varying user preference in intensity of each of the one or more tactile transducers 104 relative to the main audio level (e.g., audible sound generated by speaker 106).

Intensity control LUT 228 is a table stored in memory 114 that associates discrete intensity control 234 values (e.g., 0 through 10, or a 0-255 slider value) with one or more gain values. In one embodiment, the table stores a single scalar for each intensity control 234 value. In addition, the table can store a vector so that N channel conditioned audio signal can be processed differently. Table entries are set during calibration and can be updated over time. Audio output application 116 reads intensity control 234 values selected by one or more users, performs a direct or interpolated lookup in intensity control LUT 228, and provides the resulting one or more gain values to first level module 218 and tactile processing unit 212. First level module 218 generates leveled N channel conditioned audio signal.

Experience setting module 219 receives the leveled N channel conditioned audio signal generated by first level module 218 and applies tactile experience adjustments based on an experience setting control signal corresponding to experience setting control 236 selected by a user. Experience setting module 219 generates N channel adjusted signal. Delay module 220 receives N channel adjusted signal and applies per-channel delay to each individual N channel adjusted signal according to experience parameters (e.g., a delay vector). Delay module 220 introduces relative timing differences between individual channels to generate perceptual effects such as motion or spatial spread. Delay module 220 generates N channel delayed signal. Transient shaping module 221 receives N channel delayed signal. Transient shaping module 221 applies controllable transient shaping operations including attack, sustain, and decay characteristics of the N channel delayed signal to modify perceived user feelings. For example, emphasizing sharper impacts or smoother rumbling feelings to match user preferences or content type.

Experience setting control 236, provided by one or more users via user interface 108, is translated by audio output application 116 into tactile experience parameters based on a corresponding experience setting control signal using experience setting control LUT 230. Experience setting control LUT 230 includes mappings of experience setting control 236 tactile experiences (e.g., predefined modes such as "Punch," "Smooth," "Cinema," or "Gaming") to corresponding tactile experience parameters or pre-configured signal processing settings. In some embodiments, experience setting control 236 enables adjustment of tactile experiences (e.g., a slider spanning "Punch" to "Rumble" or "Cinema" to "Gaming"). Experience setting control LUT 230 stores experience parameters as a N-element gain vector, per-channel delay values, transient shaping parameters, and/or an N × N routing matrix coefficients. The selected gain vector and/or routing matrix coefficients are then multiplied with, or applied to, the received leveled N channel conditioned audio signal generated by first level module 218 to generate the N channel adjusted signal. The per-channel delay values are applied to the N channel adjusted signal by delay module 220 to generate N channel delayed signal. The transient shaping parameters are applied to the N channel delayed signal to generate experience-modified audio signal. As an example, seat shakers can be provided with a "Punch" tactile experience or a "Smooth" tactile experience. The output of transient shaping module 221 that reflects the desired tactile experiences is forwarded to equalizer 222 for subsequent processing.

Equalizer 222 receives the experience-modified audio signal generated by transient shaping module 221 as an equalizer setting and applies frequency-dependent processing based on a volume control signal that is based on a volume control 238 that is selected by a user. The volume control signal corresponding to volume control 238 is translated by audio output application 116 into volume parameters using volume control LUT 232. Volume control LUT 232 includes mappings of volume control 238 level (e.g., numeric steps or slider positions) to equalization parameters and level parameters including frequency bands, gains, or shelving EQ filters. Volume control LUT 232 stores equalization parameters as a N-element frequency-dependent gain vector. The selected frequency-dependent gain vector is multiplied with the received N channel audio signals generated by transient shaping module 221 to generate an equalized audio signal. The output of equalizer 222 is provided to second level module 224 for subsequent processing.

Second level module 224 receives the equalized audio signal from equalizer 222 and applies an overall scaling or gain adjustment based on the volume control signal corresponding to volume control 238. Volume control 238, selected by one or more users via user interface 108, is translated by audio output application 116 into a volume control signal and volume parameters using volume control LUT 232. Volume control LUT 232 includes mappings of volume control 238 level (e.g., numeric steps or slider positions) to equalization parameters and level parameters including frequency bands, gains, or shelving EQ filters. Volume control LUT 232 stores level parameters as an overall gain parameter. The selected overall gain parameter is multiplied with the received N channel audio signals generated by equalizer 222 to generate an N channel leveled audio signal. The output of second level module 224 is forwarded to limiter 226.

Limiter 226 receives the N channel leveled audio signal from second level module 224 and applies a dynamic limiting operation to prevent leveled audio signal amplitude from exceeding a predetermined threshold. Thus, limiter 226 protects tactile transducer 104 from excessive drive signals that can cause distortion or mechanical damage by reducing gain to keep leveled audio signal amplitude within acceptable bounds. In some embodiments, limiter 226 is configured as a hard limiter that enforces a ceiling level compatible with downstream hardware including tactile transducer 104. Limiter 226 parameters, including threshold, attack time, hold time, release time, and ceiling level, are stored in memory 114 and are selectable or adjustable based on tactile transducer 104 specifications. Attack time defines how quickly limiter 226 responds when an audio signal exceeds the threshold, hold time specifies the duration that limiter 226 maintains gain reduction after the audio signal falls below the threshold to prevent abrupt fluctuations, and release time controls how rapidly limiter 226 returns to normal operation following the expiration of the hold time. The fully conditioned N channel audio signal is generated as processed audio signal 240. Processed audio signal 240 can be delivered to tactile transducer 104 or a driver circuitry including an amplifier (not shown).

Intensity control 234 enables one or more users to adjust vibrations intensity of each of the one or more tactile transducers 104 via a static or slowly varying gain value. In some embodiments, intensity control 234 can include a rotary dial, a vertical slider on a touchscreen, or a voice command (e.g., increase seat vibration). Audio output application 116 translates the vibrations intensity adjustments selected by one or more users into gain values retrieved from intensity control LUT 228.

Experience setting control 236 provides the user the ability to select or configure among a plurality of predefined or user-configured tactile experiences. Each tactile experience specifies a N-element gain vector, per-channel delay values, transient shaping parameters, and/or N × N routing matrix coefficients that determine how a group of tactile transducers 104 generates vibrations (e.g., driver seat group, back seat group, passenger side group, and/or the like). For example, in tactile experience of "Punch", tactile transducers can generate a centralized vibration feeling, while, in tactile experience of "Rumble", tactile transducers can generate a loose or whole-seat vibration feeling. In some embodiments, experience setting control 236 can include a mode-selection button cycling through icons on a display, a touchscreen menu showing tactile experience names, or a gesture recognized by a cabin camera. Audio output application 116 translates the tactile experience selected by one or more users into tactile experience parameters retrieved from experience setting control LUT 230.

Volume control 238 adjusts output volume via equalization parameters and level parameters (e.g., gain, frequency bands, and/or other volume control parameters) applied downstream of intensity control and experience setting control. The volume control scales the composite tactile drive signal, thereby adjusting the overall amplitude haptic output. In some embodiments, volume control can include a primary audio-system knob, steering-wheel buttons, up/down keys, or a spoken command (e.g., set volume to fifty percent). Audio output application 116 translates the overall vibrations intensity selected by one or more users into volume parameters retrieved from volume control LUT 232.

Processed audio signal 240 generated by limiter 226 represents a fully conditioned N channel audio signal for driving tactile transducers 104. Processed audio signal 240 is delivered from audio output application 116 to tactile transducers 104 via appropriate driver circuitry, allowing consistent, effective, and immersive tactile feedback aligned with user-specified intensity, experience, and volume settings.

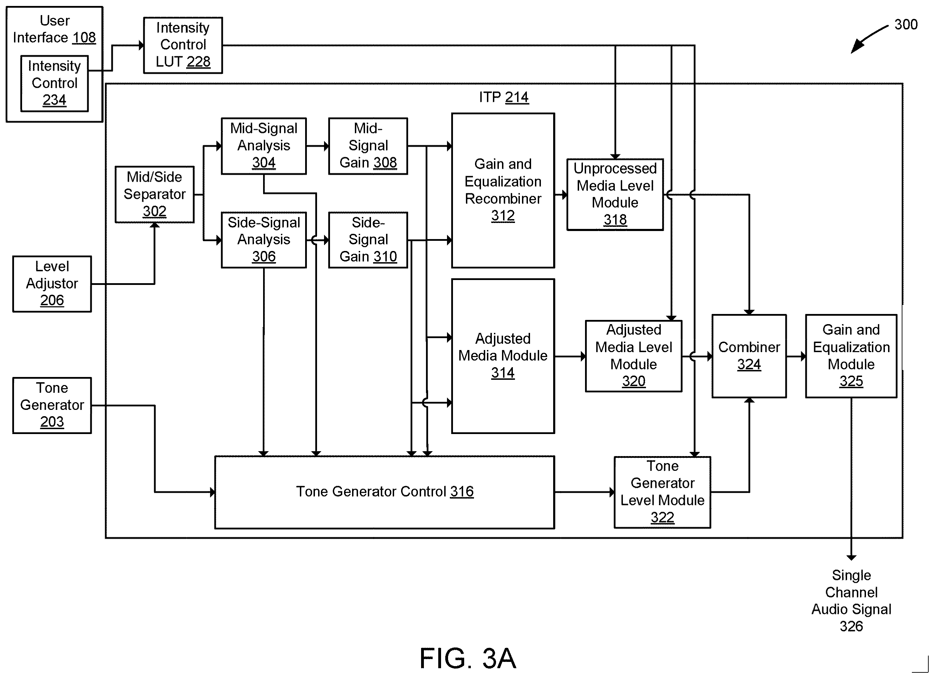

FIG. 3A is a more detailed illustration of an individual tactile processing unit ITP 214, according to various embodiments. As shown, ITP 214 receives one or more gain values from intensity control LUT 228 based on intensity control 234 values selected by one or more users. ITP 214 also receives the normalized audio signal generated by level adjustor 206 and the periodic low-frequency waveform from tone generator 203. ITP 214 processes the normalized audio signal, one or more gain values, and the periodic low-frequency waveform to generate a single channel audio signal 326, or a preprocessed audio signal. ITP 214 includes, without limitation, a mid/side separator 302, a mid-signal analysis 304, a side-signal analysis 306, a mid-signal gain 308, a side-signal gain 310, a gain and equalization recombiner 312, an adjusted media module 314, a tone generator control 316, an unprocessed media level module 318, an adjusted media level module 320, a tone generator level module 322, a combiner 324, and a gain and equalization module 325.

Mid/side separator 302 receives the normalized audio signal generated by level adjustor 206. Mid/side separator 302 separates the received normalized audio signal into mid and side components enabling independent processing of shared and unique audio elements between left (L) and right (R) audio channels. The mid signal represents common audio content (L+R) and is provided to mid-signal analysis 304 for further processing. The side signal represents differential audio content (L-R) and is provided to side-signal analysis 306 for further processing. Mid/side separator 302 employs mid-side encoding techniques that utilize sum-and-difference operations to generate mid and side signals. If the incoming signal is monophonic, both left and right audio channels are identical, thus the side signal becomes digital zero.

Mid-signal analysis 304 processes the mid signal provided by mid/side separator 302. Mid-signal analysis 304 evaluates the mid signal characteristics, such as amplitude, frequency, and transient response, and generates mid signal metrics along with the mid signal. The mid signal metrics, computed over a specific time window (e.g., 10-100 ms) and are sent to mid-signal gain 308 and to tone generator control 316 for subsequent gain or triggering operations on the mid signal.

Side-signal analysis 306 processes the side signal provided by mid/side separator 302. Side-signal analysis 306 evaluates the side signal characteristics, such as amplitude, frequency, and transient response, and generates side signal metrics along with the side signal. The side signal metrics, computed over a specific time window (e.g., 10-100 ms), are sent to side-signal gain 310 and to tone generator control 316 for subsequent gain or triggering operations on the side signal.

Mid-signal gain 308 receives the mid signal metrics along with the mid signal generated by mid-signal analysis 304. Mid-signal gain 308 applies frequency-dependent equalization (EQ) and/or amplitude gain adjustments based on mid signal metrics and predefined parameters stored in memory 114. The predefined parameters of mid-signal gain 308 include, center frequency, bandwidth, gain amount, and equalizer type (e.g., parametric, graphic, or shelving), are retrieved from memory 114. Mid-signal gain 308 predefined parameters can be selected or dynamically adjusted based on mid signal metrics or tactile transducer 104. The processed mid signal generated by mid-signal gain 308 is subsequently provided to gain and equalization recombiner 312, adjusted media module 314, and tone generator control 316.

Side-signal gain 310 receives the side signal metrics along with the side signal generated by side-signal analysis 306. Side-signal gain 310 applies frequency-dependent equalization (EQ) and/or amplitude gain adjustments based on side signal metrics and predefined parameters stored in memory 114. The predefined parameters of side-signal gain 310 include, center frequency, bandwidth, gain amount, and equalizer type (e.g., parametric, graphic, or shelving), are retrieved from memory 114. Side-signal gain 310 predefined parameters can be selected or dynamically adjusted based on side signal metrics or tactile transducer 104. The processed side signal generated by side-signal gain 310 is subsequently provided to gain and equalization recombiner 312, adjusted media module 314, and tone generator control 316.

Gain and equalization recombiner 312 receives the processed mid signal generated by mid-signal gain 308 and the processed side signal generated by side-signal gain 310. Gain and equalization recombiner 312 applies frequency-dependent equalization (EQ) and/or amplitude gain adjustments based on parameters stored in memory 114. The parameters include center frequency, bandwidth, gain amount, and equalizer type (e.g., parametric, graphic, or shelving), which are selectable and adjustable based on tactile transducer specifications. After independently processing the processed mid signal and the processed side signal, gain and equalization recombiner 312 generates modified mid signal and modified side signal. Gain and equalization recombiner 312 combines the modified mid and side signals using mid-side decoding techniques (e.g., sum and difference operations) to reconstruct enhanced left and enhanced right audio channels. Mid-side decoding techniques include calculating enhanced left and enhanced right audio channels from the modified mid signal and the modified side signal. The recombined signals generated by gain and equalization recombiner 312 are subsequently provided to unprocessed media level module 318 for further processing.

Adjusted media module 314 receives the processed mid signal generated by mid-signal gain 308 and the processed side signal generated by side-signal gain 310. Adjusted media module 314 independently applies dynamic range control operations, including clipping, limiting, and/or expanding, to each of the processed mid signal and processed side signal. Clipping operations apply instantaneous amplitude constraints to increase the energy delivered to tactile transducers 104 by raising the RMS of the mid signal and the side signal. Limiting operations provide dynamic compression based on configurable threshold, attack, hold, and release parameters retrieved from memory 114, smoothly controlling peak levels of processed mid signal and processed side signal. Expanding operations increase the dynamic range of processed mid signal and processed side signal by reducing processed mid signal and processed side signal amplitude below a specified threshold (downward expansion) or increasing processed mid signal and processed side signal amplitude above a specified threshold (upward expansion), according to expansion parameters including attack, release, threshold, ratio, and range stored in memory 114.

Adjusted media module 314 further applies frequency-dependent equalization (EQ) and/or amplitude gain adjustments based on parameters stored in memory 114. The parameters include center frequency, bandwidth, gain amount, and equalizer type (e.g., parametric, graphic, or shelving), which are selectable and adjustable based on tactile transducer specifications. After independently processing the processed mid signal and the processed side signal, adjusted media module 314 generates adjusted mid signal and adjusted side signal. Adjusted media module 314 recombines the adjusted mid signal and the adjusted side signal using mid-side decoding techniques (e.g., sum and difference operations), generating adjusted left and adjusted right audio channels. Mid-side decoding techniques include calculating adjusted left and adjusted right audio channels from the adjusted mid signal and the adjusted side signal. The combined adjusted signal generated by adjusted media module 314 is provided to adjusted media level module 320 for additional level adjustments.

Tone generator control 316 receives and processes the periodic low-frequency waveform from tone generator 203, the mid signal metrics generated by mid-signal analysis 304, the side signal metrics generated by side-signal analysis 306, the processed mid signal generated by mid-signal gain 308, and the processed side signal generated by side-signal gain 310 to generate a tone generated signal.

Tone generator control 316 splits the periodic low-frequency waveform into a first signal branch and a second signal branch with a splitter. Tone generator control 316 performs frequency modulation and wave shaping on the first signal branch based on mid signal metrics and performs an analogous frequency modulation and wave shaping on the second signal branch based on side signal metrics. The frequency modulation and wave shaping dynamically adjust the fundamental frequency of the oscillator, harmonic content, and amplitude so that the periodic low-frequency waveform tracks or otherwise complements the spectrum, and the level indicated by the mid signal metrics and side signal metrics, thereby generating vibrations that perceptually complement the mid signal metrics.

The modulated first signal branch is sent to a first gate whose open and close states are determined by the short-term RMS level of the processed mid signal (e.g., the first gate opens when the processed mid signal level exceeds -20 dBFS and closes when the processed mid signal level falls below -24 dBFS). The modulated second signal branch is sent to a second gate whose open and close states are determined by the short-term RMS level of the processed side signal (e.g., the second gate opens when the processed side signal level exceeds -20 dBFS and closes when the processed side signal level falls below -24 dBFS). The tone generator control 316 multiplies the output of each gate by an envelope. Envelope time constants (e.g., 5 ms attack, 50 ms hold, 10 ms release) are stored in memory 114. Subsequently, the outputs of the two signal branches are combined. The resulting tone generated signal is forwarded to tone generator level module 322 for further processing.

Intensity control LUT 228 is a table stored in memory 114 that associates discrete intensity control 234 values (e.g., 0 through 10, or a 0-255 slider value) with one or more gain values. Unprocessed media level module 318 receives one or more gain values from intensity control LUT 228 and the recombined signals generated by gain and equalization recombiner 312. Unprocessed media level module 318 processes the recombined signals generated by gain and equalization recombiner 312 to generate a leveled recombined signal by multiplying the recombined signals with one or more gain values received from intensity control LUT 228. The leveled recombined signal is provided to combiner 324.

Adjusted media level module 320 receives one or more gain values from intensity control LUT 228 and the combined adjusted signal generated by adjusted media module 314. Adjusted media level module 320 processes the combined adjusted signal generated by adjusted media module 314 to generate a leveled adjusted signal by multiplying the combined adjusted signal with one or more gain values received from intensity control LUT 228. The leveled adjusted signal is provided to combiner 324.

Tone generator level module 322 receives one or more gain values from intensity control LUT 228 and the tone generated signal generated by tone generator control 316. Tone generator level module 322 processes the tone generated signal generated by tone generator control 316 to generate a leveled tone generated signal by multiplying the tone generated signal with one or more gain values received from intensity control LUT 228. The leveled tone generated signal is provided to combiner 324.

Combiner 324 receives the leveled recombined signal generated by unprocessed media level module 318, the leveled adjusted signal generated by adjusted media level module 320, and the leveled tone generated signal generated by tone generator level module 322. Combiner 324 sums the leveled recombined signal, the leveled adjusted signal, and the leveled tone generated signal to generate a single channel combined signal.

Gain and equalization module 325 receives the single channel combined signal generated by combiner 324. Gain and equalization module 325 applies frequency-dependent equalization (EQ) and/or amplitude gain adjustments based on parameters stored in memory 114.The parameters include center frequency, bandwidth, gain amount, and equalizer type (e.g., parametric, graphic, or shelving), which are selectable and adjustable based on tactile transducer specifications. After processing single channel combined signal, gain and equalization module 325 generates single channel audio signal 326. Single channel audio signal 326 is provided to signal conditioning module 216 for further processing.

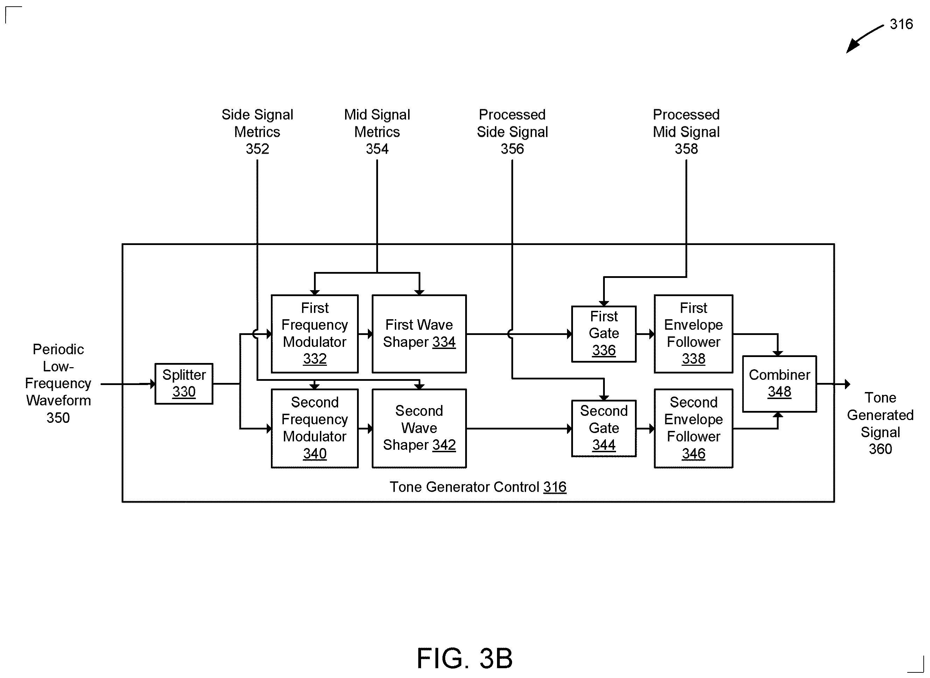

FIG. 3B is a more detailed illustration of tone generator control 316, according to various embodiments. As shown, tone generator control 316 includes, without limitation, a splitter 330, a first frequency modulator 332, a first wave shaper 334, a first gate 336, a first envelope follower 338, a second frequency modulator 340, a second wave shaper 342, a second gate 344, a second envelope follower 346, and a combiner 348. Tone generator control 316 receives and processes periodic low-frequency waveform 350, side signal metrics 352, mid signal metrics 354, processed side signal 356, and processed mid signal 356 to generate tone generated signal 360.

As noted above, tone generator control 316 receives a periodic low-frequency waveform 350 generated by tone generator 203. The periodic low-frequency waveform is provided to splitter 330 within tone generator control 316. Splitter 330 splits periodic low-frequency waveform 350 into a first signal and a second signal.

First frequency modulator 332 receives the first signal and mid signal metrics 354 generated by mid-signal analysis 304. First frequency modulator 332 dynamically adjusts the fundamental frequency of the oscillator and harmonic content of the first signal such that the generated modulated first signal tracks or otherwise complements the spectrum of mid signal metrics 354.

First wave shaper 334 receives modulated first signal generated by first frequency modulator 332 and mid signal metrics 354 generated by mid-signal analysis 304. First wave shaper 334 applies wave-shaping operations to the modulated first signal, including operations that alter the wave shape of the modulated first signal such as pitch adjustment, expansion, compression, distortion, transient shaping, and/or the like. First wave shaper 334 employs wave-shaping operations to generate a shaped first signal.

First gate 336 receives the shaped first signal generated by first wave shaper 334 and processed mid signal 358. The open and close states of first gate 336 are determined by the short-term RMS level of the processed mid signal 358 (e.g., first gate 336 opens when processed mid signal 358 level exceeds -20 dBFS and closes when processed mid signal 358 level falls below -24 dBFS). First envelope follower 338 receives output of first gate 336 to generate a first processed signal. First envelope follower 338 multiplies the output of first gate 336 by an envelope. Envelope time constants (e.g., 5 ms attack, 50 ms hold, 10 ms release) are stored in memory 114. The generated first processed signal is provided to combiner 348.

Second frequency modulator 340 receives the second signal and side signal metrics 352 generated by side-signal analysis 306. Second frequency modulator 340 dynamically adjusts the fundamental frequency of the oscillator and harmonic content of the second signal such that the generated modulated second signal tracks or otherwise complements the spectrum of side signal metrics 352.

Second wave shaper 342 receives modulated second signal generated by second frequency modulator 340 and side signal metrics 352 generated by side-signal analysis 306. Second wave shaper 342 applies wave-shaping operations to the modulated second signal, including operations that alter the wave shape of the modulated second signal such as pitch adjustment, expansion, compression, distortion, transient shaping, and/or the like. Second wave shaper 342 employs wave-shaping operations to generate a shaped second signal.

Second gate 344 receives the shaped second signal generated by second wave shaper 342 and processed side signal 356. The open and close states of second gate 344 are determined by the short-term RMS level of the processed side signal 356 (e.g., second gate 344 opens when processed side signal 356 level exceeds -20 dBFS and closes when processed side signal 356 level falls below -24 dBFS). Second envelope follower 346 receives output of second gate 344 to generate a second processed signal. Second envelope follower 346 multiplies the output of second gate 344 by an envelope. Envelope time constants (e.g., 5 ms attack, 50 ms hold, 10 ms release) are stored in memory 114. The generated second processed signal is provided to combiner 348

Combiner 348 receives and combines the first processed signal and the second processed signal as tone generated signal 360. Accordingly, the output of the combiner 348 from tone generator control 316 is provided as tone generated signal 360 to tone generator level module 322.

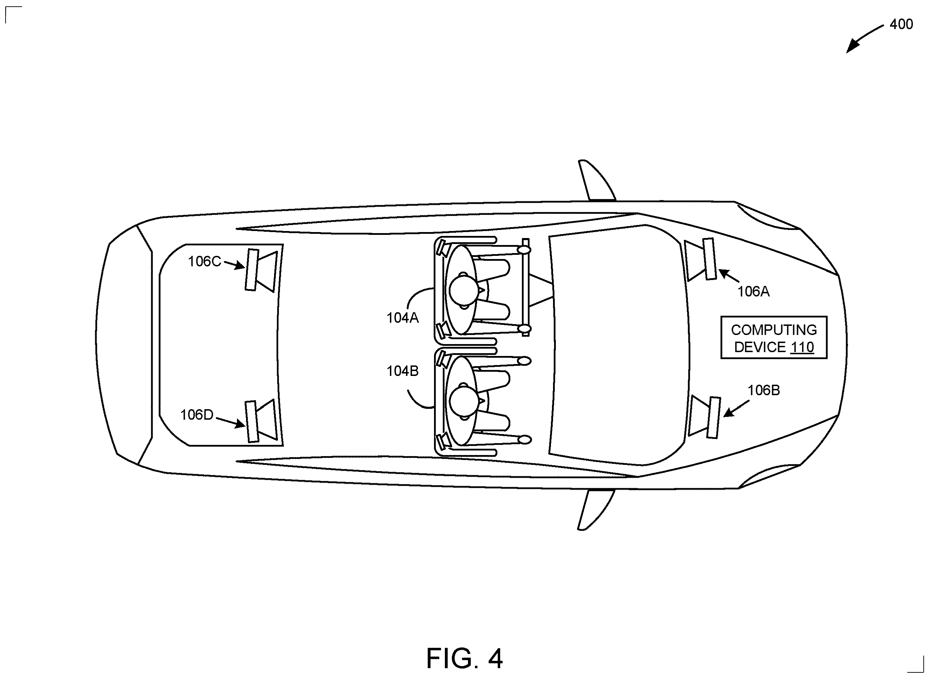

FIG. 4 illustrates an example of a vehicle-based audio system, according to various embodiments. As shown a vehicle 400 includes, without limitation, a computing device 110, tactile transducers 104, and speakers 106. Computing device 110 mounted, for example, behind the instrument panel or beneath a seat. Speaker 106A, 106B located in the front door or dash area. Speaker 106C, 106D located in the rear area or rear doors. Tactile transducer 104A mechanically coupled to the seat base or backrest of the driver seat and tactile transducer 104B mounted in an analogous position on the passenger seat.

Each tactile transducer 104A, 104B converts the dedicated single channel audio signal 326 generated by corresponding ITP 214(i) into vibrations. Computing device 110 generates left-channel amplified or pre-amplified electrical drive signals to front speaker 106A and rear speaker 106C, right-channel amplified or pre-amplified electrical drive signals to front speaker 106B and rear speaker 106D, and any center amplified or pre-amplified electrical drive signals to a suitable weighted mixture of all speaker 106A, 106B, 106C, and 106D.

Computing device 110 dynamically adjusts audio signals and tactile sensations based on user-selected settings via user interface 108, audio content characteristics, or spatial audio rendering techniques. For example, when computing device 110 processes a music track whose dominant kick-drum appears equally in the left and right channels, computing device 110 directs the amplified or pre-amplified electrical drive signals to both front speaker 106A, 106B and rear speaker 106C, 106D equally. Audio output application 116 drives tactile transducer (that can include one or more tactile transducers 104A and 104B in each group) to generate a vertical or horizontal haptic movements felt by both occupants. In some embodiments, tactile transducer 104A and 104B includes a group of tactile transducers in each seat.

In another example, when a video game sound effect is panned hard right, audio output application 116 sends a higher-level tactile burst to the right side of the passenger-side group of tactile transducers 104B and the right side of the driver-side group of tactile transducers 104A. Audio output application 116 also sends lower-level or zero burst to the left side of the passenger-side tactile group of tactile transducers 104B and the left side of the driver-side group of tactile transducer 104A. Although FIG. 4 shows a four-speaker configuration with two groups of tactile transducers 104, the disclosed techniques are compatible with any technically feasible number or placement of speakers 106 and/or tactile transducers 104 within a vehicle cabin or similar environment.

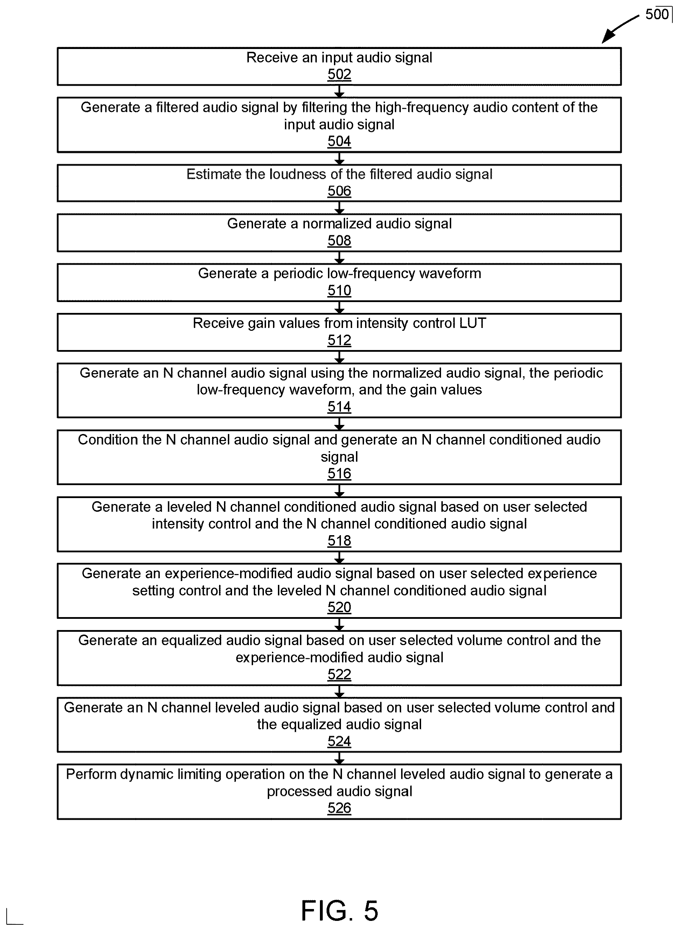

FIG. 5 is a flow diagram of method steps for generating processed audio signal 240 from input audio signal 202, according to various embodiments. Although the method steps are described with reference to the embodiments of FIGs 1-4, persons skilled in the art will understand that any system configured to implement the method steps, in any order, falls within the scope of the present disclosure.

Method 500 begins at step 502, where audio output application 116 receives input audio signal 202 from head unit 102. Input audio signal 202 can originate from any technically feasible audio source, including terrestrial or satellite radio broadcasts, audio streams from network-based services, local playback from a smartphone or other mobile device, stored media files containing music, movie soundtracks, spoken word recordings, podcasts, or any combination thereof. In some embodiments, input audio signal 202 can include one channel, two channels, or multiple discrete channels and can have any technically feasible length and sample rate.

At step 504, LPF 204 generates a filtered audio signal by filtering out the high-frequency audio content of input audio signal 202. LPF 204 is a digital or analog low-pass filter that isolates low-frequency audio content (e.g., below 200 Hz) of input audio signal 202. LPF 204 attenuates (e.g., by 60 dB) input audio signal 202 above a predetermined or programmable cutoff frequency (e.g., approximately 200 Hz), thereby extracting low-frequency audio content of input audio signal 202 and filtering the high-frequency audio content of input audio signal 202. In some embodiments, LPF 204 employs a multiband filter that divides the low-frequency audio content into two or more contiguous sub-bands (e.g., 20-50 Hz, 50-80 Hz, 80-120 Hz, and 120-200 Hz). LPF 204 generates a filtered audio signal that includes a low-frequency signal or a set of sub-band signals.

At step 506, loudness estimator 208 estimates the loudness of the filtered audio signal. Loudness estimator 208 calculates the loudness of the resulting audio signal filtered by LPF 204 using LUFS. In operation, loudness estimator 208 continuously evaluates the low-frequency signal or the set of sub-band signals within the filtered audio signal and updates computed LUFS values in real-time or at periodic intervals. In a low-frequency signal implementation (e.g., 200 Hz and below), level adjustor 206 employs loudness estimator 208 operating on the low-frequency signal. In a set of sub-band signals implementation (e.g., four sub-bands), level adjustor 206 employs a corresponding plurality of loudness estimators 208 (e.g., one per sub-band), each generating an independent LUFS value.

At step 508, ramping gain controller 210 generates a normalized audio signal. Ramping gain controller 210 applies a rate-limiting algorithm that gradually adjusts the gain factor to adjust loudness or amplitude of the filtered audio signal with current LUFS values toward loudness or amplitude of the low-frequency signal or the set of sub-band signals with target values in LUFS over a predefined duration. The ramping duration and/or minimum/maximum gain bounds can be selected or adjusted via parameters stored in memory 114. Ramping gain controller 210 multiplies the gain factor with the filtered audio signal to generate a normalized audio signal.

At step 510, tone generator 203 generates a periodic low-frequency waveform. Tone generator 203 generates a periodic low-frequency waveform, such as a triangle wave or square wave, activated when the normalized audio signal exceeds a predefined threshold level determined by tone generator control 316. Tone generator 203 parameters, including waveform type, fundamental frequency, and gating threshold, are stored in memory 114 and can be updated over time.

At step 512, tactile processing unit 212 receives gain values from intensity control LUT 228. Intensity control LUT 228 assigns discrete intensity control 234 values (e.g., 0 through 10, or a 0-255 slider value) with one or more gain values. Audio output application 116 translates selected intensity control 234 values to the static or slowly varying gain values using intensity control LUT 228.

At step 514, tactile processing unit 212 generates an N channel audio signal using the normalized audio signal, the periodic low-frequency waveform, and the gain values. Tactile processing unit 212 includes a set of N individual tactile processing units ITP 214(i) where N corresponds to an identifier of a tactile transducer 104 (e.g., four tactile transducers in a seat base and two in a seatback imply N = 6). Tactile processing unit 212 generates an N-channel audio signal, where each channel is generated specifically for each of one or more tactile transducers 104. Each ITP 214(i) independently processes the received signals by tactile processing unit 212 for each of one or more tactile transducers 104.

Mid-side signal analysis within each ITP 214(i) separates the received normalized audio signal into mid and side components, or a weighted mixture thereof, enabling independent processing of shared and unique audio elements between left (L) and right (R) audio channels. The mid signal represents common audio content (L+R), and the side signal represents differential audio content (L-R).

Each ITP 214(i) individually processes the normalized audio signal generated by level adjustor 206 by performing clipping, limiting, and/or expanding operations for each left (L) and right (R) audio channels through adjusted media module 314 to manage and control dynamic range, preventing distortion and protecting tactile transducer 104 from excessive drive levels. Clipping modules apply instantaneous amplitude constraints, while limiting modules apply dynamic range compression based on configurable attack, hold, and release parameters stored in memory 114. Expanding operations increase the dynamic range of the audio signal, performing downward expansion to reduce the level of an audio signal below a specified threshold (e.g., making quiet signals quieter) or upward expansion to boost an audio signal above the specified threshold (e.g., making loud signals louder). Expansion parameters, including attack, release, threshold, ratio, and range are stored in memory 114 and can be updated or selected according to tactile transducer 104.

Each ITP 214(i) also includes tone generator control 316. Tone generator control 316 monitors the amplitude of the normalized audio signal generated by level adjustor 206. When an instantaneous or short-term RMS level exceeds a programmable trigger threshold stored in memory 114 (e.g., -18 dBFS after normalization), tone generator control 316 asserts a trigger flag "T_ON." When the level falls below the programmable trigger threshold or after an adjustable hold-time expires, tone generator control 316 de-asserts the flag. Tone generator control 316 multiplies the output of tone generator 203 by an envelope. Envelope time constants (e.g., 5 ms attack, 50 ms hold, 10 ms release) are stored in memory 114.

Each individual ITP 214(i) performs further signal conditioning on the received signals based on intensity control LUT 228. Signal conditioning provides additional filtering, gain adjustments, delay adjustments, and summation as needed to generate a single channel audio signal. Tactile processing unit 212 aggregates outputs from each individual ITP 214(i) as the N channel audio signal, or a multi-channel signal.

At step 516, signal conditioning module 216 conditions the N channel audio signal and generates an N channel conditioned audio signal. Signal conditioning module 216 receives the N channel audio signal through an N × N matrix mixer. Each mixer coefficient of the matrix mixer is selectable from a lookup table or set dynamically by audio output application 116. Signal conditioning module 216 performs additional processing operations on the N channel audio signal, including compression, gain adjustment, delay adjustments, or equalization (EQ) to generate N channel conditioned audio signal. Compressor module within signal conditioning module 216 dynamically controls the dynamic range of each audio channel, smoothly reducing the N channel audio signal amplitude above a predetermined threshold based on configurable attack, hold, and release parameters stored in memory 114. Gain adjustment modules apply a fixed or configurable gain to scale the amplitude of the N channel audio signal. Equalizer module applies frequency-dependent filtering, such as parametric EQ, graphic EQ, or shelving filters, to selectively boost or attenuate specific frequency ranges of the N channel audio signal. Equalization parameters, including center frequency, bandwidth, and gain, are stored and retrieved from memory 114.

At step 518, first level module 218 generates a leveled N channel conditioned audio signal based on user selected intensity control and the N channel conditioned audio signal. First level module 218 receives the N channel conditioned audio signal from signal conditioning module 216 and applies a static or slowly varying gain value to the N channel conditioned audio signal based on intensity control 234 values selected by one or more users. Audio output application 116 translates selected intensity control 234 values to the static or slowly varying gain values using intensity control LUT 228. Audio output application 116 reads intensity control 234 values selected by one or more users, performs a direct or interpolated lookup in intensity control LUT 228, and provides the resulting one or more gain values to first level module 218 and tactile processing unit 212. First level module 218 generates leveled N channel conditioned audio signal.

At step 520, transient shaping module 221 generates an experience-modified audio signal based on user selected experience setting control and the leveled N channel conditioned audio signal. Experience setting module 219 receives the leveled N channel conditioned audio signal generated by first level module 218 and applies tactile experience adjustments based on user-selected experience setting control 236. Experience setting control 236 tactile experiences, provided by one or more users via user interface 108, are translated by audio output application 116 into tactile experience parameters using experience setting control LUT 230. Experience setting control LUT 230 includes mappings of experience setting control 236 tactile experiences to corresponding tactile experience parameters or pre-configured signal processing settings. Experience setting control LUT 230 stores experience parameters as a N-element gain vector, per-channel delay values, transient shaping parameters, and/or an N × N routing matrix coefficients. The selected gain vector and/or routing matrix coefficients are then multiplied with, or applied to, the received leveled N channel conditioned audio signal generated by first level module 218 to generate the N channel adjusted signal. The per-channel delay values are applied to the N channel adjusted signal by delay module 220 to generate N channel delayed signal. The transient shaping parameters are applied to the N channel delayed signal to generate experience-modified audio signal that reflects the desired tactile experiences.

At step 522, equalizer 222 generates an equalized audio signal based on user selected volume control and the experience-modified audio signal. Equalizer 222 receives the experience-modified audio signal generated by experience transient shaping module 221 and applies frequency-dependent processing based on volume control 238. Volume control 238, selected by one or more users via user interface 108, is translated by audio output application 116 into volume parameters using volume control LUT 232. Volume control LUT 232 includes mappings of volume control 238 level (e.g., numeric steps or slider positions) to equalization parameters and level parameters including frequency bands, gains, or shelving EQ filters. Volume control LUT 232 stores equalization parameters as an N-element frequency-dependent gain vector. The selected frequency-dependent gain vector is multiplied with the received N channel audio signals generated by transient shaping module 221 to generate an equalized audio signal.

At step 524, second level module 224 generates an N channel leveled audio signal based on user selected volume control and the equalized audio signal. Second level module 224 receives the equalized audio signal from equalizer 222 and applies an overall scaling or gain adjustment based on volume control 238. Volume control 238, employed by one or more users via user interface 108, is translated by audio output application 116 into volume parameters using volume control LUT 232. Volume control LUT 232 includes mappings of volume control 238 level (e.g., numeric steps or slider positions) to equalization parameters and level parameters including frequency bands, gains, or shelving EQ filters. Volume control LUT 232 stores level parameters as an overall gain parameter. The selected overall gain parameter is multiplied with the received N channel audio signals generated by equalizer 222 to generate an N channel leveled audio signal.

At step 526, limiter 226 performs dynamic limiting operation on the N channel leveled audio signal to generate processed audio signal 240. Limiter 226 receives the N channel leveled audio signal from second level module 224 and applies a dynamic limiting operation to prevent leveled audio signal amplitude from exceeding a predetermined threshold. In some embodiments, limiter 226 is configured as a hard limiter that enforces a ceiling level compatible with downstream hardware including tactile transducer 104. Limiter 226 parameters, including threshold, attack time, hold time, release time, and ceiling level, are stored in memory 114 and are selectable or adjustable based on tactile transducer 104 specifications. The fully conditioned N channel audio signal is generated as processed audio signal 240. Processed audio signal 240 can be delivered to tactile transducer 104 or a driver circuitry including an amplifier.

In sum, the disclosed techniques receive a full-bandwidth audio signal, separate low-frequency components of the audio signal using one or more low-pass or multiband filters, calculate loudness units relative to full scale (LUFS) for each band in real time, and apply an automatic, perceptually weighted gain ramp that normalizes vibration amplitude to a target level before subsequent signal conditioning. Mid-side decomposition retains stereophonic cues. A gated tone generator generates triangle or square waves at a predefined frequency provides consistency in the bass level and prevents perceptual gaps. Lookup table mappings convert user selections for intensity, experience settings, and volume into deterministic gain and equalizer settings, after which a limiter and envelope shaping prepare final drive signals for one or more integrated tactile transducers.

At least one technical advantage of the disclosed techniques relative to prior art is the provision of automatic loudness-based gain control. The gain control delivers perceptually uniform vibration across audio signals with different intensity levels. Consequently, the gain control eliminates manual track-by-track calibration and prevents either under-stimulation or excessive discomfort vibrations. Additional advantages include multiband processing in which the audio signal is split into several frequency bands so vibration can be matched to different frequency bands. In addition, mid/side audio signal processing preserves stereophonic separation. Furthermore, user-based selections enable customization of different vibration intensities to different tactile transducers, per-channel delay adjustments, and transient shaping operations.
1. In some embodiments, a computer-implemented method comprises receiving an input audio signal for playback by at least one speaker and at least one tactile transducer, receiving a control signal associated with a user-specified setting for the at least one tactile transducer, and generating a processed audio signal to drive the at least one tactile transducer, wherein the processed audio signal is adjusted based on the control signal independent of a speaker output signal driving the at least one speaker.
2. The computer-implemented method of clause 1, wherein the control signal corresponds to an intensity control signal, and the method further comprises applying a gain to the input audio signal based on the intensity control signal.
3. The computer-implemented method of clauses 1 or 2, wherein the gain is applied to the input audio signal based on a calculated loudness value associated with a set of sub-bands generated from the input audio signal.
4. The computer-implemented method of any of clauses 1-3, further comprising generating a conditioned input audio signal to which the gain is applied.
5. The computer-implemented method of any of clauses 1-4, wherein generating the conditioned input audio signal comprises applying at least one of compression, gain adjustment, delay adjustment, or equalization to the input audio signal.
6. The computer-implemented method of any of clauses 1-5, wherein the conditioned input audio signal is based on a preprocessed audio signal, and the method further comprises generating the preprocessed audio signal based on the input audio signal, and wherein generating the preprocessed audio signal comprises separating the input audio signal using mid-side separation into a first signal and a second signal, applying a first gain to the first signal and a second gain to the second signal, and combining the first signal and the second signal to generate the preprocessed audio signal.
7. The computer-implemented method of any of clauses 1-6, wherein the preprocessed audio signal comprises a multi-channel signal, wherein the multi-channel signal comprises a plurality of channels and wherein each channel from the plurality of channels corresponds to a tactile transducer from a plurality of tactile transducers.
8. The computer-implemented method of any of clauses 1-7, wherein the control signal corresponds to an experience control signal, and the method further comprises selecting from a plurality of pre-configured signal processing settings that adjust the input audio signal to generate the speaker output signal.
9. The computer-implemented method of any of clauses 1-8, further comprising filtering the input audio signal with a low pass filter to generate a filtered signal, wherein the processed audio signal is based on the filtered signal.
10.The computer-implemented method of any of clauses 1-9, wherein the control signal corresponds to a volume control signal, and the method further comprises adjusting a gain of the processed audio signal based on the volume control signal.
11.The computer-implemented method of any of clauses 1-10, further comprising selecting an equalizer setting from a plurality of predefined equalizer settings based on the volume control signal, wherein the equalizer setting comprises a frequency-dependent gain vector.
12.The computer-implemented method of any of clauses 1-11, further comprising normalizing the input audio signal by applying a ramping gain adjustment to the input audio signal.
13.In some embodiments, one or more non-transitory computer-readable media store instructions that, when executed by one or more processors, cause the one or more processors to perform the steps of receiving an input audio signal for playback by at least one speaker and at least one tactile transducer, receiving a control signal associated with a user-specified setting for the at least one tactile transducer, and generating a processed audio signal to drive the at least one tactile transducer, wherein the processed audio signal is adjusted based on the control signal independent of a speaker output signal driving the at least one speaker.
14.The one or more non-transitory computer-readable media of clause 13, wherein the control signal corresponds to an intensity control signal, and the method further comprises applying a gain to the input audio signal based on the intensity control signal.
15.The one or more non-transitory computer-readable media of clauses 13 or 14, wherein the steps further comprise generating a conditioned input audio signal to which the gain is applied.
16.The one or more non-transitory computer-readable media of any of clauses 13-15, wherein generating the conditioned input audio signal comprises applying at least one of compression, gain adjustment, delay adjustment, or equalization to the input audio signal.
17.The one or more non-transitory computer-readable media of any of clauses 13-16, wherein the conditioned input audio signal is based on a preprocessed audio signal, and the steps further comprise generating the preprocessed audio signal based on the input audio signal, and wherein generating the preprocessed audio signal comprises separating the input audio signal using mid-side separation into a first signal and a second signal, applying a first gain to the first signal and a second gain to the second signal, and combining the first signal and the second signal to generate the preprocessed audio signal.
18.The one or more non-transitory computer-readable media of any of clauses 13-17, wherein the preprocessed audio signal comprises a multi-channel signal, wherein the multi-channel signal comprises a plurality of channels and wherein each channel from the plurality of channels corresponds to a tactile transducer from a plurality of tactile transducers.
19.The one or more non-transitory computer-readable media of any of clauses 13-18, wherein the control signal corresponds to an experience control signal, and the steps further comprise selecting from a plurality of pre-configured signal processing settings that adjust the input audio signal to generate the speaker output signal.
20.In some embodiments, a system comprises at least one tactile transducer, at least one speaker, a memory storing instructions, and one or more processors, that when executing the instructions, are configured perform the steps of receiving an input audio signal for playback by at least one speaker and at least one tactile transducer, receiving a control signal associated with a user-specified setting for the at least one tactile transducer, and generating a processed audio signal to drive the at least one tactile transducer, wherein the processed audio signal is adjusted based on the control signal independent of a speaker output signal driving the at least one speaker.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method, comprising:
receiving an input audio signal for playback by at least one speaker and at least one tactile transducer;
receiving a control signal associated with a user-specified setting for the at least one tactile transducer; and
generating a processed audio signal to drive the at least one tactile transducer, wherein the processed audio signal is adjusted based on the control signal independent of a speaker output signal driving the at least one speaker.

2. The computer-implemented method of claim 1, wherein the control signal corresponds to an intensity control signal, and the method further comprises applying a gain to the input audio signal based on the intensity control signal.

3. The computer-implemented method of claim 2, wherein the gain is applied to the input audio signal based on a calculated loudness value associated with a set of sub-bands generated from the input audio signal.

4. The computer-implemented method of claim 2, further comprising generating a conditioned input audio signal to which the gain is applied.

5. The computer-implemented method of claim 4, wherein generating the conditioned input audio signal comprises applying at least one of compression, gain adjustment, delay adjustment, or equalization to the input audio signal.

6. The computer-implemented method of claim 4, wherein the conditioned input audio signal is based on a preprocessed audio signal, and the method further comprises generating the preprocessed audio signal based on the input audio signal, and wherein generating the preprocessed audio signal comprises separating the input audio signal using mid-side separation into a first signal and a second signal, applying a first gain to the first signal and a second gain to the second signal, and combining the first signal and the second signal to generate the preprocessed audio signal.

7. The computer-implemented method of claim 6, wherein the preprocessed audio signal comprises a multi-channel signal, wherein the multi-channel signal comprises a plurality of channels and wherein each channel from the plurality of channels corresponds to a tactile transducer from a plurality of tactile transducers.

8. The computer-implemented method of claim 1, wherein the control signal corresponds to an experience control signal, and the method further comprises selecting from a plurality of pre-configured signal processing settings that adjust the input audio signal to generate the speaker output signal.

9. The computer-implemented method of claim 1, further comprising filtering the input audio signal with a low pass filter to generate a filtered signal, wherein the processed audio signal is based on the filtered signal.

10. The computer-implemented method of claim 1, wherein the control signal corresponds to a volume control signal, and the method further comprises adjusting a gain of the processed audio signal based on the volume control signal.

11. The computer-implemented method of claim 10, further comprising selecting an equalizer setting from a plurality of predefined equalizer settings based on the volume control signal, wherein the equalizer setting comprises a frequency-dependent gain vector.

12. The computer-implemented method of claim 1, further comprising normalizing the input audio signal by applying a ramping gain adjustment to the input audio signal.

13. One or more non-transitory computer-readable media storing instructions that, when executed by one or more processors, cause the one or more processors to perform the steps of:
receiving an input audio signal for playback by at least one speaker and at least one tactile transducer;
receiving a control signal associated with a user-specified setting for the at least one tactile transducer; and
generating a processed audio signal to drive the at least one tactile transducer, wherein the processed audio signal is adjusted based on the control signal independent of a speaker output signal driving the at least one speaker.

14. The one or more non-transitory computer-readable media of claim 13, wherein the instructions, when executed by one or more processors, cause the one or more processors to perform the steps of a method as mentioned in any of claims 2 to 12.

15. A system comprising:
at least one tactile transducer;
at least one speaker;
a memory storing instructions; and
one or more processors, that when executing the instructions, are configured perform the steps of:
receiving an input audio signal for playback by at least one speaker and at least one tactile transducer;
receiving a control signal associated with a user-specified setting for the at least one tactile transducer; and
generating a processed audio signal to drive the at least one tactile transducer, wherein the processed audio signal is adjusted based on the control signal independent of a speaker output signal driving the at least one speaker.
